# EUROPEAN PATENT APPLICATION

(11) **EP 4 502 630 A1**
(43) Date of publication of application: **05.02.2025**
(21) Application number: 23780781.3
(22) Date of filing: 29.03.2023
(51) Int. Cl.: G01R 31/26, G01R 31/28

(54) **TEMPERATURE ADJUSTMENT DEVICE, INSPECTION DEVICE, AND TEMPERATURE ADJUSTMENT METHOD**

(30) Priority: 30.03.2022 JP 2022056931
(71) Applicant: Nidec Advance Technology Corporation, Muko-shi, Kyoto 617-0003 (JP)
(72) Inventor: GUNJI, Keita, Muko-shi, Kyoto 617-0003 (JP); KISHIDA, Yoichi, Muko-shi, Kyoto 617-0003 (JP); ISA, Takashi, Muko-shi, Kyoto 617-0003 (JP)
(74) Representative: Viering, Jentschura & Partner mbB Patent- und Rechtsanwälte
(86) International application number: PCT/JP2023/013000
(87) International publication number: WO 2023/190773

(57) **Abstract**

Provided are a temperature adjustment device capable of easily shortening time for setting internal temperature of an object whose temperature is to be adjusted to a target temperature range, an inspection device for inspecting the object, and a temperature adjustment method. A temperature adjustment device 1 includes a housing 2, a cooling table 61 arranged in the housing 2 and having a cooling surface 611 that can be in contact with an object DUT, a cooling unit 64 that cools the cooling table 61 to cooling temperature TC lower than a lower limit value TL of a preset target temperature range, a conveyance mechanism 5 that separates the object DUT from the cooling surface 611 after bringing the object DUT into contact with the cooling surface 611, and a fan 25 that heats the object DUT separated from the cooling surface 611 by the conveyance mechanism 5.

## Description

### TECHNICAL FIELD

The present invention relates to a temperature adjustment device that adjusts temperature of an object, an inspection device that inspects the object, and a temperature adjustment method.

### BACKGROUND ART

Conventionally, there has been known a technique of cooling a circuit board to be inspected to a predetermined temperature range (0°C ± 3°C) by placing the circuit board to be inspected on a cooling plate set to predetermined set temperature (0°C) (see, for example, Patent Literature 1).

### CITATIONS LIST

### PATENT LITERATURE

Patent Literature 1: JP 2012-022001 A (paragraphs 0095 and 0104)

### SUMMARY OF INVENTION

### TECHNICAL PROBLEMS

When an object to be cooled is a thin substrate as described above, a temperature difference hardly occurs between a surface of the substrate and the inside of the substrate. However, when thickness of an object to be cooled is large, it takes time to cool the inside by heat conduction if a surface of an object is cooled.

An object of the present invention is to provide a temperature adjustment device capable of easily shortening time for setting internal temperature of an object whose temperature is to be adjusted to a target temperature range, an inspection device for inspecting the object, and a temperature adjustment method.

### SOLUTIONS TO PROBLEMS

A temperature adjustment device according to an example of the present invention includes a housing, a cooling table arranged in the housing and having a cooling surface that can be in contact with an object, a cooling unit that cools the cooling table to cooling temperature lower than a lower limit value of a preset target temperature range, a conveyance mechanism that separates the object from the cooling surface after bringing the object into contact with the cooling surface, and a heating unit that heats the object separated from the cooling surface by the conveyance mechanism.

Further, an inspection device according to an example of the present invention includes the temperature adjustment device described above, an inspection table that is arranged in the housing and on which the object can be placed, and an inspection unit that inspects the object placed on the inspection table, in which the conveyance mechanism places the object on the inspection table after separating the object from the cooling surface.

A temperature adjustment method according to an example of the present invention includes a cooling step of cooling a cooling table to cooling temperature lower than a lower limit of a target temperature range set in advance, the cooling table being arranged in a housing and having a cooling surface that can be in contact with an object, and a temperature adjustment step of cooling the object by bringing the object into contact with the cooling surface, separating the cooled object from the cooling surface, and heating the separated object to bring the object close to the target temperature range.

### ADVANTAGEOUS EFFECTS OF INVENTION

The temperature adjustment device, the inspection device, and the temperature adjustment method having such a configuration can easily shorten time for setting internal temperature of an object whose temperature is to be adjusted to the target temperature range.

### BRIEF DESCRIPTION OF DRAWINGS

FIG. 1 is a conceptual perspective view illustrating an example of an appearance of an inspection device using a temperature adjustment method according to an embodiment of the present invention.
FIG. 2 is an explanatory view of an internal space of a housing 2 as viewed from above (+Z direction).
FIG. 3 is a conceptual perspective view illustrating an example of a configuration of a cooling block 6.
FIG. 4 is a conceptual perspective view illustrating an example of a configuration of a heating block 3.
FIG. 5 is a conceptual explanatory diagram illustrating an example of a cross-sectional structure of an object DUT.
FIG. 6 is a conceptual explanatory diagram of the inside of the housing 2 of an inspection device 1 illustrated in FIG. 1 as viewed from a -Y direction.
FIG. 7 is a flowchart illustrating an example of operation of the inspection device 1 illustrated in FIG. 6.
FIG. 8 is a graph illustrating an example of a temperature change of the object DUT.
FIG. 9 is a partially enlarged diagram of FIG. 8.

### DESCRIPTION OF EMBODIMENT

Hereinafter, an embodiment of the present invention will be described with reference to the drawings. Note that configurations with the same reference numerals in the drawings indicate the same configurations and are omitted from description. In each diagram, XYZ orthogonal coordinate axes are appropriately shown in order to clarify a directional relationship. In each diagram, a Z direction is described as up and down, and X and Y directions are described as left and right or front and back directions. However, a correspondence relationship between the X, Y, and Z directions and up and down, left and right, and front and back directions is not limited to the above.

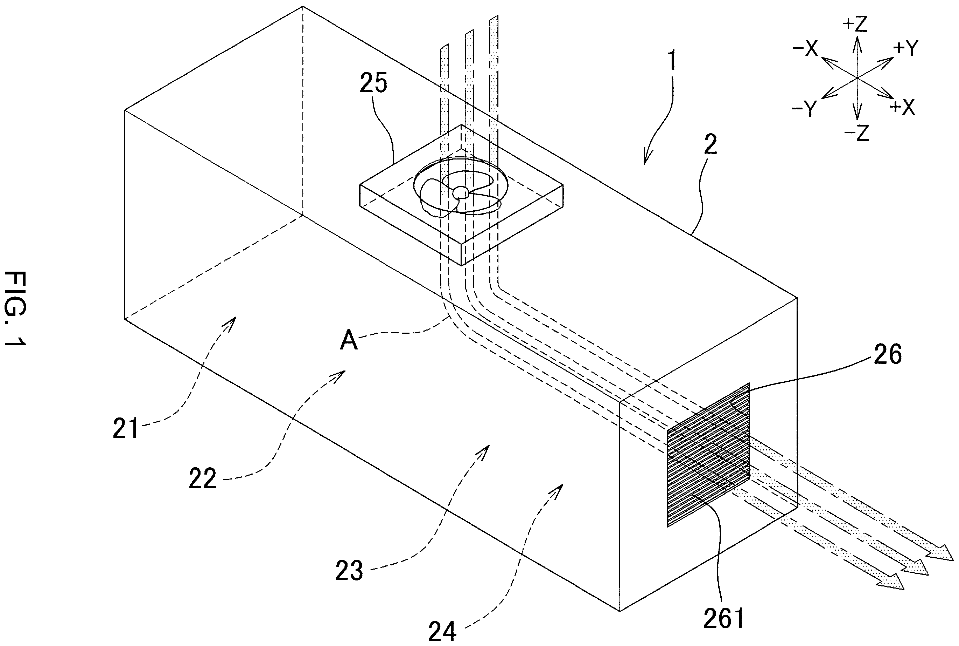

An inspection device 1 illustrated in FIG. 1 includes a housing 2 having a substantially rectangular parallelepiped outer shape, for example. Note that an outer shape of the housing 2 is not limited to a substantially rectangular parallelepiped shape. In an internal space of the housing 2, a heating region 21, a high-temperature inspection region 22, a cooling region 23, and a room-temperature inspection region 24 are provided in this order from the -X side. A fan 25 (heating unit) is attached to an upper surface of the housing 2 between the high-temperature inspection region 22 and the cooling region 23. An opening portion 26 is provided on a wall surface on the room-temperature inspection region 24 side (+X side) of the housing 2. In FIG. 1, a filter 261 is attached to the opening portion 26.

The fan 25 takes air from the outside of the housing 2 into the housing 2 and blows the air to generate airflow A that passes through the cooling region 23 and the room-temperature inspection region 24 and exits from the opening portion 26. The fan 25 corresponds to an example of a heating unit. The heating unit may be, for example, an infrared heating device. Note that the fan 25 may be configured to suck air from the inside to the outside of the housing 2, take air into the housing 2 through the opening portion 26, and generate airflow in a direction opposite to the airflow A. Further, positions of the fan 25 and the opening portion 26 may be switched so that the fan 25 takes in air from the inside to the outside of the housing 2, and air is taken into the housing 2 from the opening portion 26 to generate the airflow A.

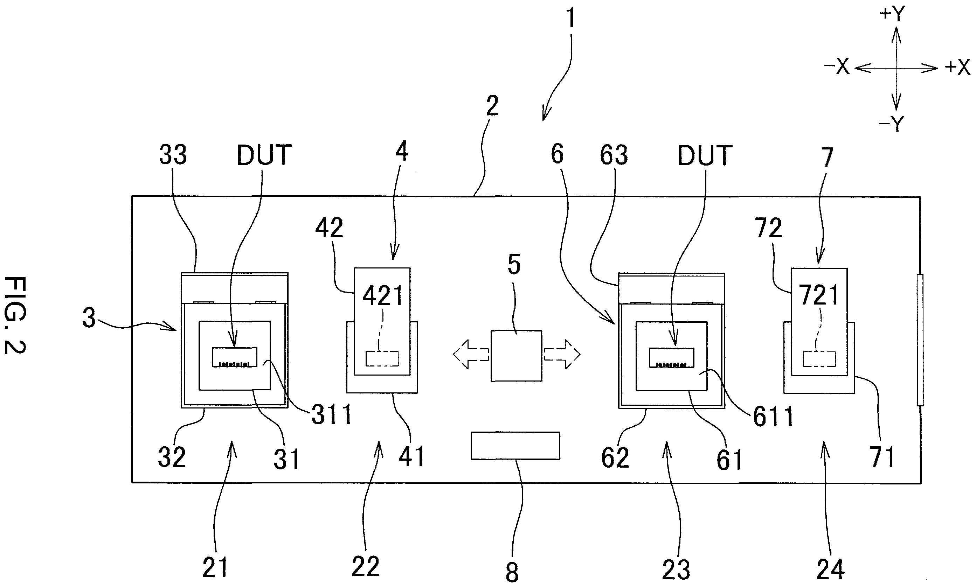

The inspection device 1 illustrated in FIG. 2 includes a heating block 3, a high-temperature inspection block 4, a conveyance mechanism 5, a cooling block 6, a room-temperature inspection block 7, and a control unit 8 in the housing 2. The heating block 3 is arranged in the heating region 21, the high-temperature inspection block 4 is arranged in the high-temperature inspection region 22, the cooling block 6 is arranged in the cooling region 23, and the room-temperature inspection block 7 is arranged in the room-temperature inspection region 24.

A portion excluding the heating block 3, the high-temperature inspection block 4, and the room-temperature inspection block 7 from the inspection device 1 corresponds to an example of a temperature adjustment device.

The conveyance mechanism 5 includes, for example, a robot hand or a gripper (not illustrated), and can grip the object DUT. Then, the conveyance mechanism 5 can convey the object DUT to the heating block 3, the high-temperature inspection block 4, the cooling block 6, and the room-temperature inspection block 7 by moving in an internal space of the housing 2.

The control unit 8 includes, for example, a central processing unit (CPU) that executes predetermined logical operation, a random access memory (RAM) that temporarily stores data, a nonvolatile storage device, a timer circuit, a peripheral circuit of these, and the like. Then, the control unit 8 controls operation of each unit in the housing 2 by executing a predetermined control program.

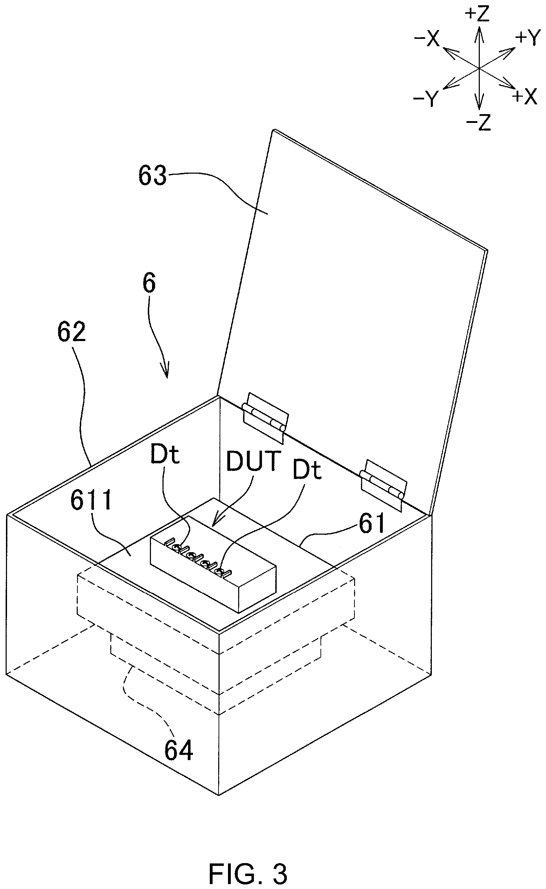

The cooling block 6 illustrated in FIG. 3 includes a cooling table 61, a cover portion 62, a lid portion 63, and a cooling unit 64.

The cooling table 61 has a cooling surface 611 that can contact the object DUT. The cooling table 61 is made from a material having high thermal conductivity such as aluminum. The cooling surface 611 may be flat. Further, irregularities, holes, notches, grooves, and the like may be formed on the cooling surface 611 in accordance with a shape of the object DUT. FIG. 3 illustrates a state in which the object DUT is placed on the cooling surface 611. Note that the present invention is not limited to an example in which the object DUT is placed on and in contact with the cooling surface 611. For example, the object DUT may be brought into contact with the cooling surface 611 facing the side.

The cooling unit 64 is attached to the cooling table 61. As a cooling method of the cooling unit 64, for example, various methods such as water cooling, air cooling, and electronic cooling can be used. The cooling unit 64 cools the cooling table 61 to cooling temperature TC lower than a lower limit value TL of a preset target temperature range. An upper limit value TH of the target temperature range is set to be higher than outside air temperature Ta of the housing 2, and the lower limit value TL of the target temperature range is set to be lower than the outside air temperature Ta. Further, the upper limit value TH is set to temperature lower than heating temperature Tht by the heating block 3.

The target temperature range is, for example, a temperature condition for inspection of the object DUT by the inspection unit 72. The upper limit value TH of the target temperature range is, for example, about target temperature Tt + 5°C, and the lower limit value TL of the target temperature range is, for example, about the target temperature Tt - 5°C. The target temperature Tt is a median value of the target temperature range, and is, for example, about the same temperature as the outside air temperature Ta, and is, for example, 20°C to 25°C. In description below, a case where the target temperature Tt is equal to the outside air temperature Ta will be described as an example.

The cover portion 62 has walls that cover a lateral outer periphery, that is, +X, -X, +Y, and -Y directions of the object DUT in contact with the cooling surface 611 and the cooling table 61. Further, the lid portion 63 attached in an openable and closable manner is attached to the cover portion 62. When the lid portion 63 is closed, an upper opening portion of the cover portion 62 is closed. The lid portion 63 is opened and closed by an opening and closing mechanism (not illustrated). The cover portion 62 and the lid portion 63 are made from a material having low thermal conductivity such as resin, for example.

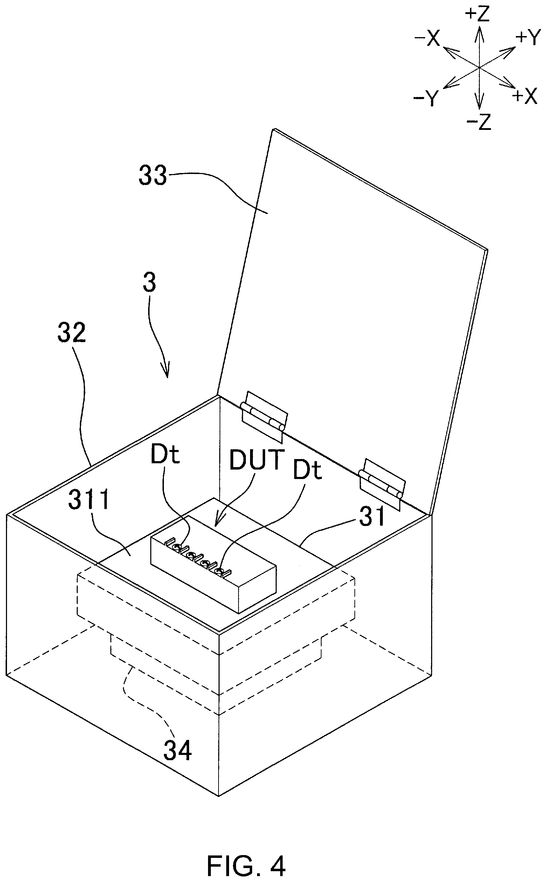

The heating block 3 illustrated in FIG. 4 includes a heating table 31, a cover portion 32, a lid portion 33, and a heating device 34. The heating table 31 includes a heating surface 311. Since the heating table 31, the heating surface 311, the cover portion 32, and the lid portion 33 are configured similarly to the cooling table 61, the cooling surface 611, the cover portion 62, and the lid portion 63, respectively, description of these will be omitted.

The heating device 34 heats the heating table 31 to the heating temperature Tht set in advance. As the heating device 34, various heating means such as a heater can be used.

The object DUT is an object to be inspected, and may be, for example, a semiconductor element such as an insulated gate bipolar transistor (IGBT) or a field effect transistor (FET). For example, as illustrated in FIG. 4, the object DUT includes a plurality of connection terminals Dt. The connection terminal Dt is, for example, a power source terminal, a signal terminal, or the like.

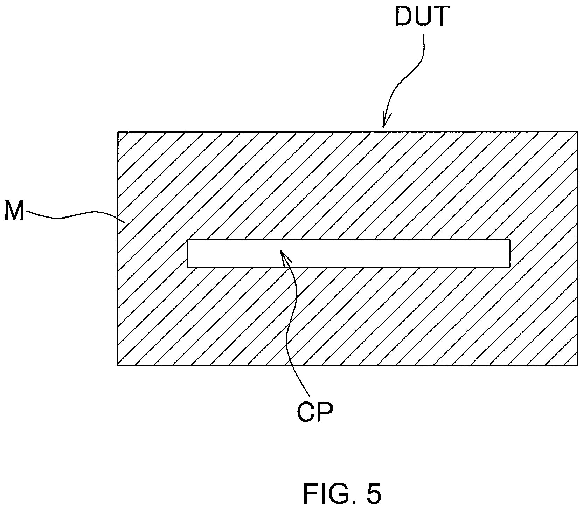

The object DUT illustrated in FIG. 5 is configured by molding a semiconductor chip CP with resin M. The resin M has low thermal conductivity, and thus has large thermal resistance between a surface of the object DUT and the semiconductor chip CP. For this reason, even if a surface of the object DUT is brought into contact with the cooling surface 611 and cooled, internal temperature ti, which is temperature of the semiconductor chip CP, is cooled later than surface temperature ts of a surface of the object DUT.

Referring to FIG. 2, the room-temperature inspection block 7 inspects the object DUT cooled by the cooling block 6. The room-temperature inspection block 7 includes an inspection table 71 on which the object DUT can be placed, and an inspection unit 72 that inspects the object DUT placed on the inspection table 71. The inspection unit 72 includes an inspection jig 721. The inspection jig 721 includes a contact terminal that comes into contact with each of the connection terminals Dt of the object DUT. The inspection jig 721 is movable up and down, and as the inspection jig 721 is lowered onto the object DUT placed on the inspection table 71, each contact terminal of the inspection jig 721 and each of the connection terminals Dt of the object DUT are brought into contact with each other.

By the above, the inspection unit 72 is electrically connected to each of the connection terminals Dt of the target object DUT via the inspection jig 721. The inspection unit 72 supplies voltage or current to any of the connection terminals Dt of the object DUT and detects voltage or current output from any of the connection terminals Dt to inspect the object DUT.

The high-temperature inspection block 4 inspects the object DUT heated by the heating block 3. The high-temperature inspection block 4 includes a high-temperature inspection table 41 on which the object DUT can be placed, and a high-temperature inspection unit 42 that inspects the object DUT placed on the high-temperature inspection table 41. The high-temperature inspection unit 42 includes an inspection jig 421. Since the high-temperature inspection table 41, the high-temperature inspection unit 42, and the inspection jig 421 are configured similarly to the inspection table 71, the inspection unit 72, and the inspection jig 721, respectively, description of these will be omitted.

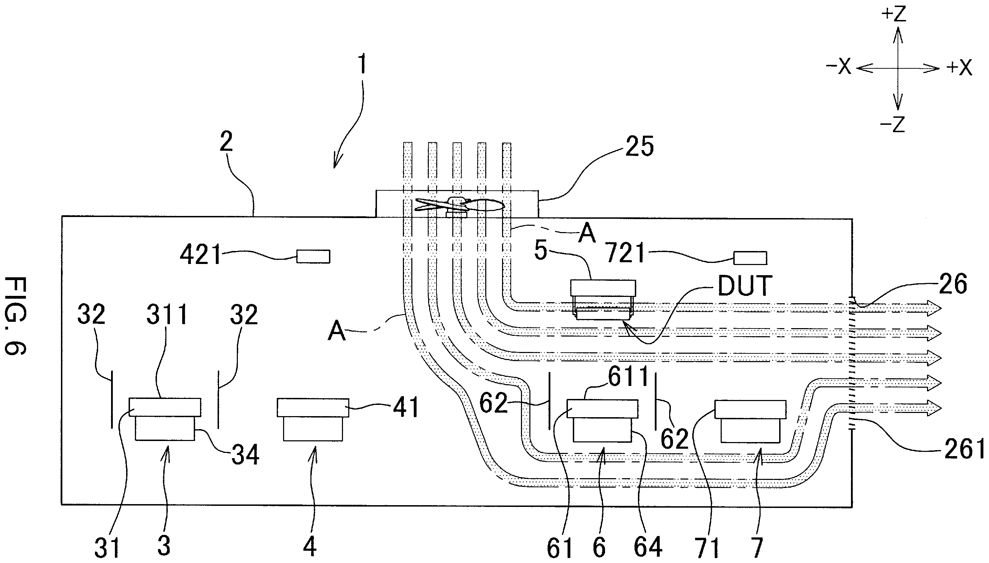

As illustrated in FIG. 6, when the conveyance mechanism 5 conveys the object DUT from the cooling block 6 to the room-temperature inspection block 7, the object DUT is conveyed through the airflow A. Therefore, the object DUT cooled by the cooling block 6 is heated so as to become close to the outside air temperature Ta. That is, the fan 25 that generates the airflow A corresponds to an example of a heating unit that heats the object DUT.

Further, in the cooling block 6, the air flow A is blocked by the cover portion 62 so as not to hit the object DUT placed on the cooling table 61 and the cooling surface 611. Therefore, cooling efficiency of the object DUT by the cooling block 6 is improved. Furthermore, by closing the lid portion 63, the airflow A does not hit the cooling table 61 or the object DUT from above, so that cooling efficiency of the object DUT is further improved.

Note that the cooling block 6 does not need to include the cover portion 62, and does not need to include the lid portion 63.

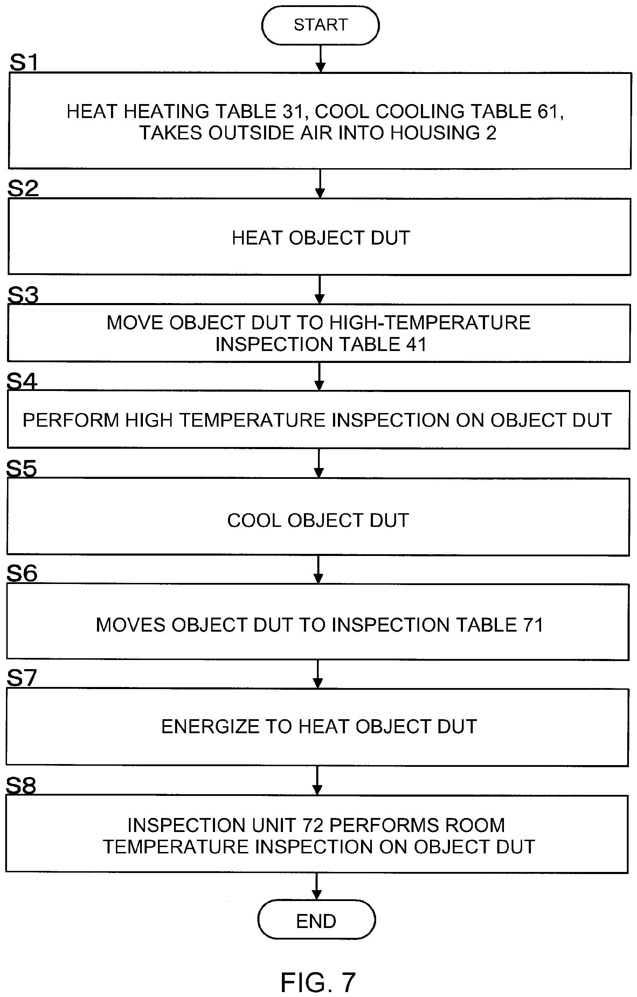

Next, operation of the inspection device 1 configured as described above will be described. Referring to FIG. 7, first, the heating device 34 heats the heating table 31 to the heating temperature Tht, the cooling unit 64 executes a cooling step of cooling the cooling table 61 to the cooling temperature TC, and the fan 25 takes outside air at the outside air temperature Ta into the housing 2 to generate the airflow A (Step S1).

Next, the control unit 8 causes the conveyance mechanism 5 to place and bring the object DUT into contact with the heating surface 311, and closes the lid portion 33 to heat the object DUT (Step S2).

After the object DUT is heated for predetermined time and reaches the heating temperature Tht, the control unit 8 opens the lid portion 33 and moves the object DUT to the high-temperature inspection table 41 by the conveyance mechanism 5 (Step S3).

The high-temperature inspection unit 42 brings the inspection jig 421 into contact with the object DUT at the heating temperature Tht placed on the high-temperature inspection table 41 to inspect the object DUT in a high-temperature state (Step S4). The heating temperature Tht is, for example, about 100°C to 200°C.

After completion of the inspection by the high-temperature inspection unit 42, the control unit 8 causes the conveyance mechanism 5 to move the object DUT to the cooling table 61 at the cooling temperature TC and place the object DUT on and in contact with the cooling surface 611, and closes the lid portion 63 to cool the object DUT (Step S5). The control unit 8 measures elapsed time from a timing t1 at which the object DUT is brought into contact with the cooling surface 611.

In the cooling block 6, the internal temperature ti of the object DUT, that is, both temperature of the semiconductor chip CP and the surface temperature ts of the object DUT are cooled so as to be within a target temperature range (the upper limit value TH to the lower limit value TL) for inspection by the inspection unit 72.

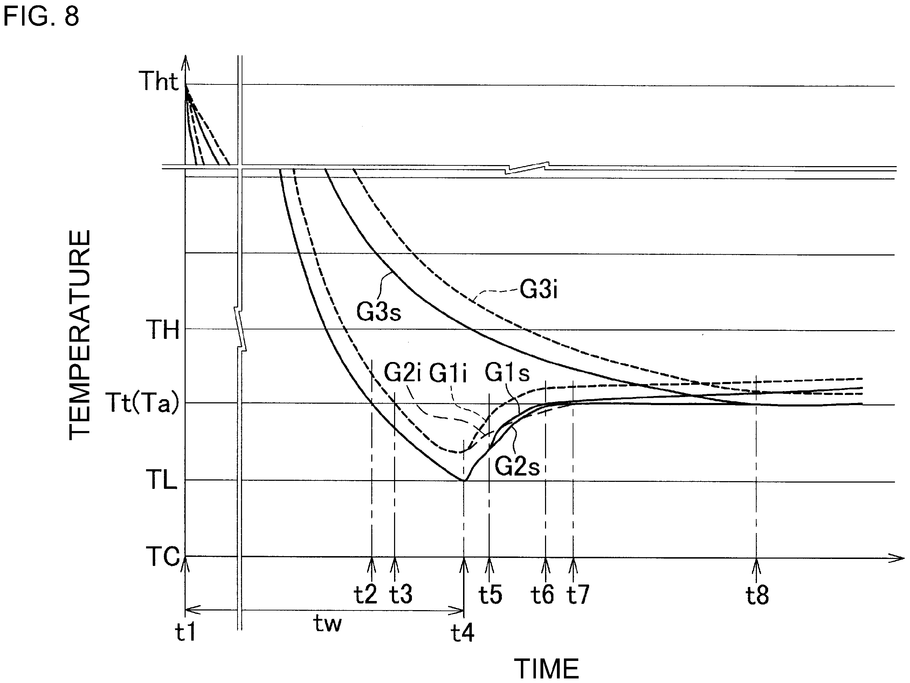

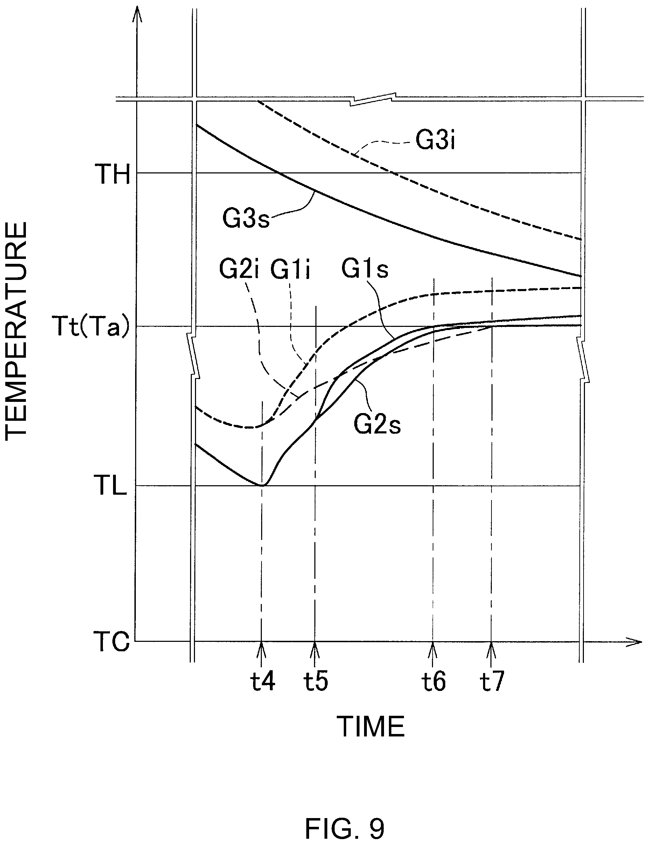

In FIGS. 8 and 9, the vertical axis represents temperature, and the horizontal axis represents elapsed time. A graph G1s indicates the surface temperature ts, and a graph G1i indicates the internal temperature ti.

A timing at which the object DUT is placed on the cooling surface 611 in Step S5 is indicated by the timing t1. As illustrated in the graph G1s, the surface temperature ts gradually decreases toward the cooling temperature TC of the cooling table 61 after the timing t1. As illustrated in the graph G1i, the internal temperature ti decreases slightly after the graph G1s.

In the example illustrated in FIG. 8, the graph G1s reaches the target temperature Tt at a timing t2, and the graph G1i reaches the target temperature Tt at a timing t3.

When preset cooling time tw elapses from the timing t1, the control unit 8 opens the lid portion 63, pulls up the object DUT by the conveyance mechanism 5 to separate the object DUT from the cooling surface 611 (timing t4), and moves the object DUT to the inspection table 71 while heating the object DUT with the airflow A (Step S6).

As the cooling time tw, time during which the surface temperature ts and the internal temperature ti of the object DUT can be cooled to temperature lower than the target temperature Tt is set in advance. The cooling time tw may be appropriately set experimentally or by simulation or the like.

Note that without limitation to an example of cooling the surface temperature ts and the internal temperature ti to temperature lower than the target temperature Tt by the cooling time tw, the control unit 8 may actually measure the surface temperature ts and the internal temperature ti and separate the object DUT from the cooling surface 611 after the temperature becomes lower than the target temperature Tt.

The object DUT pulled up from the cooling surface 611 by the conveyance mechanism 5 at the timing t4 is conveyed to the inspection table 71 through the airflow A at the outside air temperature Ta and placed on the inspection table 71 as illustrated in FIG. 6.

As a result, as illustrated in the graphs G1s and G1i, the surface temperature ts and the internal temperature ti of the object DUT increase toward the outside air temperature Ta, that is, the target temperature Tt at and after the timing t4.

Next, the inspection unit 72 brings the inspection jig 721 into contact with the object DUT placed on the inspection table 71, and applies current to the object DUT for energization to cause self-heating in the semiconductor chip CP, so as to heat the object DUT (Step S7: timing t5). The energization may also serve as current supply for electrical inspection. The inspection unit 72 that heats the object DUT by energizing the object DUT corresponds to an example of a heating unit. Steps S5 to S7 correspond to an example of a temperature adjustment step.

At the time of cooling, the internal temperature ti decreases later than the surface temperature ts. For this reason, the object DUT is brought into contact with the cooling surface 611 cooled to the cooling temperature TC lower than the lower limit value TL of a target temperature range (Step S5), and contact cooling is performed on the surface temperature ts at temperature lower than the lower limit value TL, so that a cooling speed of the internal temperature ti can be accelerated. Then, after the internal temperature ti decreases to temperature lower than the upper limit value TH, a surface of the object DUT is heated (Step S6), so that the surface temperature ts can be raised to approach the internal temperature ti. As a result, it is easy to shorten time for setting both the surface temperature ts and the internal temperature ti within the target temperature range.

Furthermore, if a surface of the object DUT is heated after the internal temperature ti decreases to temperature lower than the target temperature Tt (Step S6), as will be described later, both the surface temperature ts and the internal temperature ti can be easily maintained within the target temperature range even in a case where temperature rises due to self-heating caused by inspection current by the inspection unit 72.

Further, since the heating in Step S6 is performed during a conveyance period of the object DUT from the cooling unit 64 to the inspection table 71, it is not necessary to take time only for heating, and the object DUT can be efficiently heated.

A graph G2s represents the surface temperature ts in a case where energization is not performed at the timing t5, and a graph G2i represents the internal temperature ti in a case where energization is not performed at the timing t5. Since the graphs G1s and G1i showing energization at the timing t5 have larger temperature rise than the graphs G2s and G2i, it can be confirmed that a rising speed of the surface temperature ts and the internal temperature ti can be increased by energization.

In the examples illustrated in FIGS. 8 and 9, since the surface temperature ts and the internal temperature ti are already within the target temperature range at the timing t4, it is not necessary to increase a temperature rise speed by energization. However, in a case where the surface temperature ts is cooled to temperature lower than the lower limit value TL, time until the surface temperature ts and the internal temperature ti fall within the target temperature range can be shortened by increasing a temperature rise speed by energization.

Next, the inspection unit 72 supplies voltage or current to any of the connection terminals Dt of the object DUT via the inspection jig 721, and detects voltage or current output from any of the connection terminals Dt to perform room temperature inspection on the object DUT (Step S8) .

The inspection unit 72 can start inspection of the object DUT at and after the timing t5 at which the inspection jig 721 comes into contact with the object DUT. When the inspection unit 72 starts inspection of the object DUT, current for inspection flows through the semiconductor chip CP of the object DUT, and the semiconductor chip CP performs self-heating so that the internal temperature ti and the surface temperature ts are increased.

However, if the object DUT is conveyed from the cooling table 61 to the inspection table 71 at the timing t4 after the surface temperature ts and the internal temperature ti are once lowered to temperature lower than the target temperature Tt, it is easy to start room temperature inspection in a state where the surface temperature ts and the internal temperature ti are lower than the target temperature Tt. As a result, even in consideration of influence of temperature rise due to current for inspection, the inspection unit 72 can easily perform inspection while the surface temperature ts and the internal temperature ti are within the target temperature range.

A graph G3s illustrated in FIG. 8 indicates the surface temperature ts in a case where the object DUT at the heating temperature Tht is cooled by a conventional cooling method of bringing the object DUT into contact with the cooling surface 611 at the target temperature Tt, and a graph G3i indicates the internal temperature ti in a case where the object DUT at the heating temperature Tht is cooled by a conventional cooling method of bringing the object DUT into contact with the cooling surface 611 at the target temperature Tt.

A timing t8 at which the graph G3s reaches the target temperature Tt is later than any of a timing t6 at which the graphs G1s and G1i reach the target temperature Tt and a timing t7 at which the graphs G2s and G2i reach the target temperature Tt. As described above, in the graphs G1s, G1i, G2s, and G2i in which the object DUT is brought into contact with the cooling surface 611 cooled to the cooling temperature TC lower than the lower limit value TL of the target temperature range and then the object DUT is separated from the cooling surface 611 and heated, time until the temperature reaches the target temperature Tt is shorter than that in the graphs G3s and G3i in a case of cooling by a conventional cooling method of bringing the object DUT into contact with the cooling surface 611 at the target temperature Tt.

Then, if time until the temperature reaches the target temperature Tt is short, it means that it is easy to shorten time for setting the surface temperature ts and the internal temperature ti to the target temperature range even if a difference between the upper limit value TH and the lower limit value TL of the target temperature range is small. Further, even in the graphs G2s and G2i in a case where heating by energization on the object DUT is not performed, the heating unit does not need to perform heating by energization on the object DUT because time until the target temperature Tt is reached is shorter than that in the graphs G3s and G3i.

Further, the object DUT does not need to be a semiconductor element, and heating by energization on the object DUT does not need to be performed.

### REFERENCE SIGNS LIST

- 1: inspection device (temperature adjustment device)
- 2: housing
- 3: heating block
- 4: high-temperature inspection block
- 5: conveyance mechanism
- 6: cooling block
- 7: room-temperature inspection block
- 8: control unit
- 21: heating region
- 22: high-temperature inspection region
- 23: cooling region
- 24: room-temperature inspection region
- 25: fan (heating unit)
- 26: opening portion
- 31: heating table
- 32, 62: cover portion
- 33, 63: lid portion
- 34: heating device
- 41: high-temperature inspection table
- 42: high-temperature inspection unit
- 61: cooling table
- 64: cooling unit
- 71: inspection table
- 72: inspection unit (heating unit)
- 261: filter
- 311: heating surface
- 421, 721: inspection jig
- 611: cooling surface
- 721: inspection jig
- A: airflow
- CP: semiconductor chip
- DUT: object
- Dt: connection terminal
- M: resin
- TC: cooling temperature
- TH: upper limit value
- TL: lower limit value
- Ta: outside air temperature
- Tht: heating temperature
- Tt: target temperature
- ti: internal temperature
- ts: surface temperature
- tw: cooling time

## Claims

1. A temperature adjustment device comprising:
a housing;
a cooling table arranged in the housing and having a cooling surface that can be in contact with an object;
a cooling unit that cools the cooling table to cooling temperature lower than a lower limit value of a preset target temperature range;
a conveyance mechanism that separates the object from the cooling surface after bringing the object into contact with the cooling surface; and
a heating unit that heats the object separated from the cooling surface by the conveyance mechanism.

2. The temperature adjustment device according to claim 1, wherein the heating unit heats the object by taking air into the housing from outside the housing.

3. The temperature adjustment device according to claim 1 or 2, further comprising a cover portion that covers a lateral outer periphery of the object in contact with the cooling surface and the cooling table.

4. An inspection device comprising:
the temperature adjustment device according to any one of claims 1 to 3;
an inspection table that is arranged in the housing and on which the object can be placed; and
an inspection unit that inspects the object placed on the inspection table,
wherein the conveyance mechanism places the object on the inspection table after separating the object from the cooling surface.

5. The inspection device according to claim 4, wherein
the object includes a semiconductor element, and
the heating unit heats the object by energizing the object placed on the inspection table.

6. A temperature adjustment method comprising:
a cooling step of cooling a cooling table to cooling temperature lower than a lower limit of a target temperature range set in advance, the cooling table being arranged in a housing and having a cooling surface that can be in contact with an object; and
a temperature adjustment step of cooling the object by bringing the object into contact with the cooling surface, separating the cooled object from the cooling surface, and heating the separated object to bring the object close to the target temperature range.
